**Europäisches Patentamt**

**European Patent Office**

**Office européen des brevets**

(11) Numéro de publication : **0 224 535 B1**

(12) # FASCICULE DE BREVET EUROPEEN

(45) Date de publication du fascicule du brevet :
03.04.91 Bulletin 91/14

(51) Int. Cl.⁵ : **H03K 17/08**

(21) Numéro de dépôt : **86903418.1**

(22) Date de dépôt : **03.06.86**

(86) Numéro de dépôt international :
**PCT/FR86/00188**

(87) Numéro de publication internationale :
**WO 86/07510 18.12.86 Gazette 86/27**

(54) **APPAREIL OU CIRCUIT INTERRUPTEUR STATIQUE POUR L'ALIMENTATION PROTEGEE D'UNE CHARGE, ET DE SA LIGNE.**

(30) Priorité : 04.06.85 FR 8508381

(43) Date de publication de la demande :
10.06.87 Bulletin 87/24

(45) Mention de la délivrance du brevet :
03.04.91 Bulletin 91/14

(84) Etats contractants désignés :
CH GB IT LI SE

(56) Documents cités :
EP-A- 0 010 882
EP-A- 0 082 493
DE-A- 2 416 450
DE-A- 3 238 899
DE-B- 2 637 868
GB-A- 1 181 853
US-A- 4 351 014
US-A- 4 377 835

(56) Documents cités :
IEEE Transactions on Power Apparatus and Systems, vol. PAS-2, no. 5, May 1983, New York (US); Jinzenji et al.: "Development of zinc oxide ceramic energy absorbers for DC thyristor circuit breakers", pages 1429-1436
SIEMENS Components, vol. 19, no. 6, December 1984, Berlin (DE); Goldbrunner et al.: "Capacitors for GTO Thyristors", pages 264-268

(73) Titulaire : TELEMECANIQUE
43-45, Boulevard Franklin Roosevelt
F-92504 Rueil-Maimaison Cedex (FR)

(72) Inventeur : BELBEL, Elie
11, rue des Econdeaux
F-93800 Epinay-sur-Seine (FR)
Inventeur : FECHANT, Louis
19, rue Albert 1er
F-78110 Le Vésinet (FR)
Inventeur : RIOTTE, Jean-Paul
88, rue Saint-Gratien
F-93800 Epinay-sur-Seine (FR)

(74) Mandataire : Marquer, Francis et al
35, Avenue Victor Hugo
F-78960 Voisins le Bretonneux (FR)

EP 0 224 535 B1

## Description

L'invention concerne un appareil interrupteur électrique ayant entre deux bornes d'entrée et de sortie, un composant semi-conducteur apte à établir et interrompre le passage du courant entre ces bornes lorsqu'une électrode de commande de ce composant reçoit des signaux appropriés qui sont fournis par un circuit de commande recevant, d'une part, des ordres de conduction ou d'interruption correspondant à un fonctionnement normal et, d'autre part, des ordres de blocage qui sont émis lorsque l'intensité du courant, qui est mesurée par des moyens de détection placés en série entre ces bornes, subit une élévation anormale.

Un circuit, présentant un fonctionnement comparable à celui qui est défini ci-dessus, et qui est connu par la demande de brevet DE-OS Nr. 2.416.450, met en oeuvre un composant semi- conducteur du type triac pour alimenter de façon régulée une charge ayant une caractéristique résistive, analogue à celle d'une lampe à incandescence.

Une telle charge présente donc des variations possibles de résistance, qui sont connues à l'avance et qui se stabilisent dans un délai voisin d'une période ; le circuit, dans lequel elle se trouve placée, qui est généralement alimenté par un réseau domestique voit, par suite, passer des courants dont l'intensité des courts-circuits ne peut jamais prendre des valeurs excessives ; par ailleurs, l'utilisation d'un triac comme organe interrupteur présente ici l'inconvénient de ne pas permettre une interruption du courant alternatif à un moment quelconque de la période.

Un tel dispositif connu ne prend, par suite, nullement en compte des phénomènes transitoires tels que ceux qui apparaissent dans les circuits d'alimentation des moteurs où des surcharges, de l'ordre de cinq à six fois l'intensité nominale, peuvent se présenter au cours d'un appel de courant pouvant se prolonger pendant environ une seconde.

Par le brevet US 4 351 014, on connaît également un appareil interrupteur électrique pour la commande de l'alimentation d'une charge inductive, cet appareil comprenant entre deux bornes d'entrée et de sortie un triac apte à établir et interrompre le passage d'un courant alternatif entre ces bornes, selon des ordres de conduction ou d'interruption. Cet appareil fait en outre intervenir un circuit "Snubber" comportant une première branche conductrice comprenant un varistor, montée en parallèle entre les électrodes de puissance du composant semi-conducteur, et une deuxième branche conductrice incluant un condensateur, montée en parallèle sur ledit élément résistif à seuil.

L'invention s'intéresse, elle, à un appareil ou circuit interrupteur industriel dans lequel la charge est constituée par un moteur électrique dont la consommation peut varier dans une large gamme de valeurs en relation avec la nature des masses qu'il doit mettre en mouvement ; dans un tel circuit industriel, qui est généralement alimenté par un réseau de très faible impédance, il convient de protéger la ligne, l'organe interrupteur et la charge contre les effets de surcharges de courant et contre ceux des courts-circuits francs qui peuvent soit endommager celle-ci de façon définitive, soit provoquer la destruction de celui-ci en entraînant un arrêt prolongé de la production ; de plus, les mises en service de la charge par cet organe interrupteur correspondent à une catégorie d'emploi dont les contraintes sont beaucoup plus sévères que celles qui régissent les appareils domestiques.

La technique la plus fréquemment utilisée à ce jour pour effectuer les fonctions mentionnées ci-dessus, fait appel à une association de produits électromécaniques tels que contacteurs, relais thermiques de protection, disjoncteurs, limiteurs et fusibles dont les propriétés particulières doivent être bien choisies si l'on veut que ces fonctions soient parfaitement remplies.

L'invention se propose, par suite, de fournir un appareil ou circuit interrupteur industriel statique, qui soit susceptible à la fois d'établir et d'interrompre fréquemment par voie électronique l'alimentation d'une charge, dont l'impédance peut varier de façon accidentelle et de protéger cette charge et la ligne contre les effets des surintensités et des courts-circuits.

L'invention permet d'atteindre ce résultat grâce à un appareil interrupteur électrique pour la commande de l'alimentation d'une charge inductive, cet appareil ayant entre deux bornes d'entrée et de sortie un composant semi-conducteur apte à établir et interrompre le passage d'un courant alternatif entre ces bornes lorsqu'une électrode de commande de ce composant reçoit des signaux appropriés qui sont fournis par un circuit de commande recevant, d'une part, des ordres de conduction ou d'interruption correspondant à un fonctionnement normal et, d'autre part, des ordres de blocage qui sont émis lorsque l'intensité du courant, qui est mesurée par des moyens de détection placés en série entre ces bornes, subit une élévation anormale.

Cet appareil pourra, en outre, comprendre une troisième branche placée en parallèle sur la première branche, cette troisième branche comprenant en série une résistance limitatrice de courant apte à supporter une importante impulsion de courant et des contacts d'un interrupteur mécanique non répulsif, qui est normalement ouvert, et dont la fermeture peut être établie par un relais rapide, la bobine de ce relais n'étant alimentée que lors de l'apparition d'un premier type de défaut de durée limitée, pour lequel l'intensité présumée est sensiblement comprise entre 1,25 fois et 6 fois l'intensité nominale, et avant que soit transmis à l'électrode de commande de l'interrupteur statique un signal de blocage, tandis que cette bobine n'est pas alimentée et qu'un signal de blocage permanent est immédiatement fourni à cette électrode lorsqu'apparaît un gradient de courant supérieur à environ six fois le gradient de courant nominal signalant l'apparition d'un second type de défaut.

On sait également que des composants électroniques semi- conducteurs commandés, tels que les GTO (Gate-Turn-Off), les IGT (Isolated-Gate-Transistor) ou les GTR (Giant Transistor) présentent les propriétés de pouvoir être bloqués à tout moment d'une période de courant alternatif, connaissent actuellement des améliorations progressives de leurs caractéristiques d'isolement, d'intensité et de temps de rétablissement favorables à une utilisation industrielle de leur fonction propre.

Une telle utilisation nécessite toutefois la mise en oeuvre de mesures adaptées à la nature particulière des phénomènes qui apparaissent dans les installations correspondantes, notamment en cas de surcharges pouvant présenter un caractère répétitif.

L'invention sera mieux comprise à la lecture de la description ci-dessous et à l'examen des dessins annexés où :

La figure 1 représente de façon schématique les circuits et les fonctions qui interviennent principalement dans un appareil selon l'invention ;

La figure 2 montre l'allure d'une fonction particulière élaborée par l'un des circuits de la figure 1 ;

La figure 3 illustre un mode de réalisation préféré d'un interrupteur mécanique utilisé à la figure 1 ;

La figure 4 représente dans une vue schématique partielle, une variante des circuits de la figure 1, mettant en oeuvre un module amovible contenant certains éléments de la figure 1 ;

La figure 5 montre schématiquement un second type de détecteur de courant faisant office de fusible ;

La figure 6 illustre l'allure que peut prendre l'intensité du courant traversant une branche principale de l'appareil interrupteur lorsque celui-ci alimente une charge particulière ;

La figure 7 représente des moyens complémentaires associés à un interrupteur pour le rendre apte à exploiter les deux sens de circulation d'un courant alternatif ;

La figure 8 illustre schématiquement l'association de groupes d'interrupteurs, associés à chaque phase avec un électro-aimant commun apte à opérer des transferts de courant ;

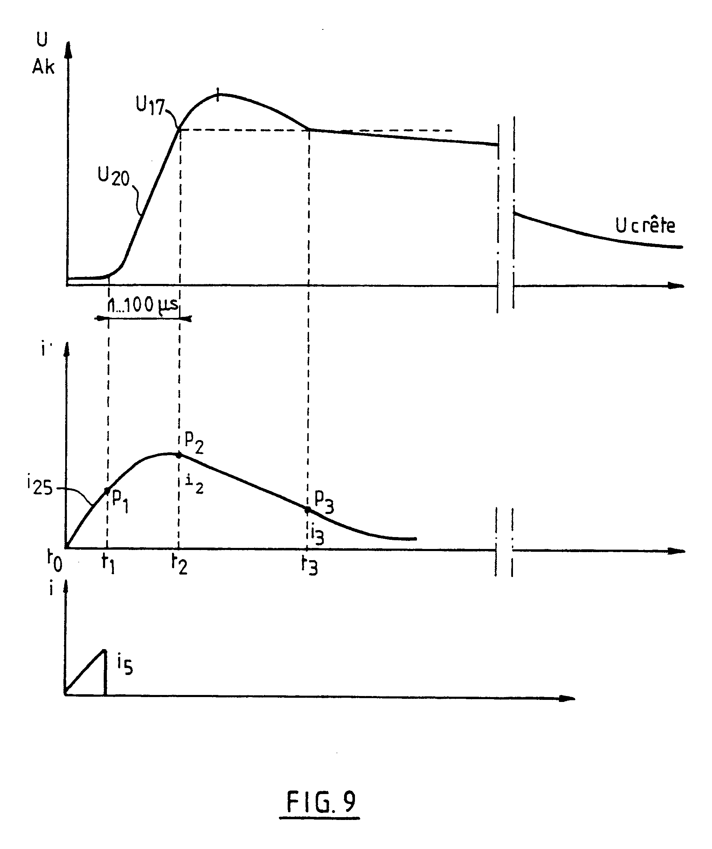

La figure 9 illustre une famille de courbes indiquant l'allure des variations de tension et de courant dans le circuit ; et

La figure 10 représente en vraie grandeur, d'une part, trois courbes de limitation opérées par trois appareils électromécaniques conventionnels et, d'autre part, la courbe de limitation opérée par un circuit interrupteur statique selon l'invention.

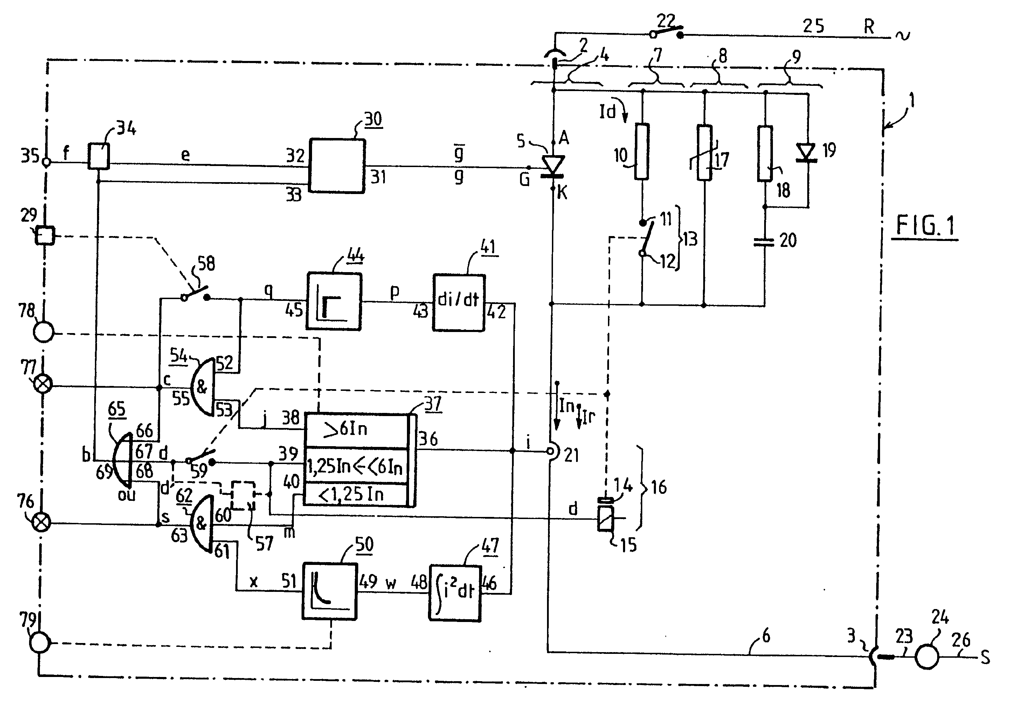

Un appareil interrupteur statique 1 visible à la figure 1 comporte une borne d'entrée de courant 2 apte à être reliée à une phase R d'un réseau alternatif comprenant, par exemple, un interrupteur 22 de sectionnement de la ligne 25, et une borne de sortie 3 apte à être reliée par un conducteur 23 à une charge 22 telle qu'un moteur 24, et par une ligne 26 à une autre phase S.

Dans une branche principale de courant 4 allant d'une borne à l'autre, est disposé un composant interrupteur électronique commandé 5 pouvant être du type GTO, GTR ou IGT. La représentation choisie dans la figure 1 concerne un GTO ayant une anode A, une cathode K et une gâchette de commande G. On sait qu'un tel interrupteur électronique ne devient passant, lorsque son anode est à un potentiel positif, que si l'on applique sur sa gâchette une impulsion positive, et ne prend son état bloqué que si l'on applique ultérieurement sur cette gâchette une impulsion négative ; un tel type d'interrupteur est donc intéressant dans la mesure où le blocage peut être établi à tout moment d'une demi-période positive de courant alternatif.

La branche principale comporte également des moyens de détection 21 de l'intensité du courant qui la traverse. Ces moyens peuvent être du type transformateur de courant, ou être constitués par une résistance de faible valeur aux bornes de laquelle la chute de potentiel représente une image du courant.

Dans une branche dérivée 8, qui est placée en parallèle sur l'anode et la cathode sont disposés en parallèle, d'une part, une résistance limitatrice de tension 17 constituée de préférence à l'aide d'un matériau tel que ZnO, ou un montage semi-conducteur faisant appel à des diodes Zener et de tension voisine de 600 V à 1000 V et, d'autre part, un montage série placé dans une branche parallèle 7 et comprenant :

– une résistance 10 composée de préférence à l'aide d'un polymère organique conducteur, et

– un interrupteur mécanique 13 ayant des contacts 11 et 12.

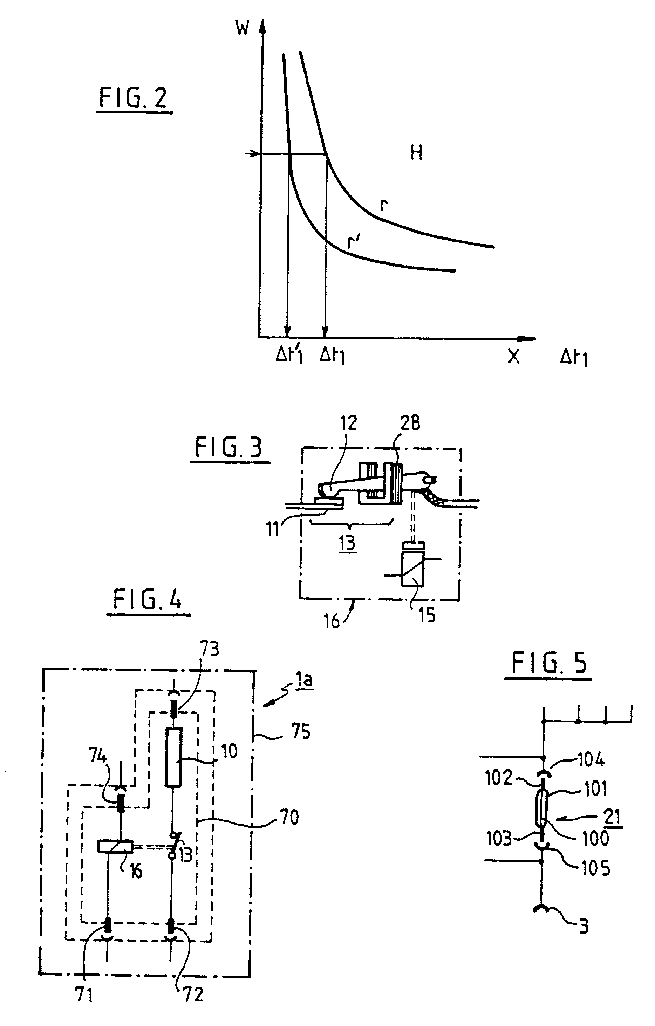

Le contact mobile 12 de cet interrupteur est relié à une palette ou noyau 14 d'un électro-aimant ou relais rapide 16 ayant une bobine d'excitation 15. Des moyens, tels qu'une structure magnétisable 28 seront avantageusement associés au contact mobile 12 pour prévenir les effets d'une répulsion électro-dynamique apparaissant lors de la circulation de courants importants, voir figure 3.

Une branche dérivée 9 placée également en parallèle comprend un circuit de protection contre les gradients de tension qui risqueraient de détériorer l'interrupteur statique 5.

Un tel circuit comprend ici un condensateur 20 placé en série avec un montage parallèle d'une résistance 18 et d'une diode 19 polarisée dans le même sens que celui de l'interrupteur statique.

Un circuit électronique de commande 30, qui est alimenté par une source de courant continu non définie sur cette figure, comporte une première entrée de commande 32 qui est reliée à une borne de commande externe 35 apte à recevoir des signaux -f- extérieurs en vue de provoquer la mise en route ou l'arrêt du dispositif interrupteur 5 ; une seconde entrée 33 du circuit 30 est destinée à recevoir un signal de blocage -b- en vue de provoquer un arrêt de la conduction du dispositif interrupteur 5 ; enfin, une sortie 31 du circuit 30 est reliée à la gâchette -G- du dispositif interrupteur 5 pour lui communiquer des signaux de commande g et $\bar{g}$ propres à établir la conduction ou le blocage de cet interrupteur.

En régime de fonctionnement normal de l'appareil 1, pour lequel la branche principale 4 sera traversée par le courant nominal In, en raison de l'absence de défauts sur la ligne 23, 26 ou la charge 24, l'interrupteur 13 est ouvert et la présence d'un signal -f- ou -$\bar{f}$- sur la borne 35 provoque l'apparition d'un signal -g- ou -$\bar{g}$- pour établir la conduction ou le blocage de l'interrupteur 5.

Le régime de fonctionnement normal résulte du fait que le détecteur de courant 21 mesure un courant compris entre les limites de ce que l'on désigne par intensité nominale In.

Lorsque le courant circulant dans la branche 4 sort de ces limites, le régime de fonctionnement n'est plus normal.

On ne s'intéressera tout d'abord qu'aux situations où le courant mesuré est soit compris entre une valeur voisine de $I_n$ et environ six fois $I_n$, soit supérieur à environ six fois $I_n$.

Dans le premier cas, le niveau anormal du courant est généralement imputable à une difficulté de mise en route de la charge ou à un ralentissement imprévu s'il s'agit d'un moteur.

Dans le second cas, le niveau excessif du courant est imputable soit à la présence d'un court-circuit franc sur la ligne 23, 26, soit à l'apparition d'un court-circuit impédant résultant d'un blocage mécanique du moteur 24.

Un signal -i-, qui est une image analogique du courant mesuré par le détecteur 21, est appliqué simultanément à l'entrée 42 d'un premier circuit 41 qui effectue une dérivation di/dt, à l'entrée 46 d'un second circuit 47 qui effectue une intégration d'une puissance de -i- qui est voisine de i², soit $\int i^2 dt$, et à l'entrée d'un circuit 37 qui effectue une discrimination de trois valeurs d'intensité possibles comprises soit entre In et environ 1,25 In, soit entre 1,25 In et 6 In, soit encore des valeurs supérieures à 6 In.

Le niveau des signaux -p- présents sur la sortie 43 du circuit 41 qui est représentatif de la croissance du courant à tout moment d'une demi-période, est analysé par un circuit détecteur de seuil 44 qui délivre à sa sortie 45 un signal -q-, si le gradient d'intensité est supérieur à un seuil de six fois le gradient d'intensité nominale.

Par intensité nominale $I_n$, on peut entendre, par exemple, la valeur crête d'une alternance de courant nominal, tandis que le gradient d'intensité nominal peut être défini par la pente P de croissance de cette intensité nominale au voisinage du zéro de courant.

Le circuit discriminateur émet sur l'une des trois sorties 18, 19, 40 l'un des trois signaux correspondants -j-, -d-, -m-.

Les signaux de sortie -j- et -q- sont appliqués aux entrées 52, 53 d'une porte ET 54, qui émet lors d'une simultanéité de ces signaux un signal -c-, aboutissant à l'une des entrées 66 d'une porte OU 65 apte à émettre le signal de blocage -b-.

Un moyen, représenté de façon schématique par un interrupteur 58, permet le cas échéant de se passer de la porte ET pour que l'émission d'un signal -c- apparaisse lorsque seul le signal -q- est présent ; l'intérêt de cette disposition apparaîtra ultérieurement.

Le signal de sortie -d- est d'une part relié à l'entrée 67 de la porte OU 65 et, d'autre part, relié à la bobine 15 de l'électro-aimant 16. On verra ultérieurement qu'un interrupteur 59 ou un circuit de retard 57 pourraient être placés entre la sortie 39 et l'entrée 67.

Dans le circuit schématique de la figure 1, rien n'indique si l'apparition d'un signal -d- produira d'abord l'apparition du signal -$\bar{g}$- ou la fermeture de l'interrupteur 13. Des mesures, telles que l'incorporation d'un circuit de retard (non représenté) entre le point -h- et l'entrée 67 sont prises pour que l'interrupteur 13 soit fermé avant que soit produit le signal -$\bar{g}$-; en variante, on peut assigner à la palette ou noyau 14 la fonction de fermeture simultanée d'un interrupteur auxiliaire tel que 59 qui est normalement ouvert et se ferme après l'interrupteur 13.

Les signaux -W-, issus du circuit intégrateur 47 qui représentent à tout moment l'énergie consommée par la charge pendant un intervalle de temps précédent de valeur déterminée, sont appliqués à l'entrée 49 d'un circuit de retard à caractéristique pseudo-hyperbolique 50 dont la sortie 51 émet un signal -x- au terme d'un intervalle de temps Δt dont l'étendue croît en sens inverse du niveau du signal W, voir figure 2.

Ce signal -x- et le signal -m- sont appliqués à une porte ET 62 dont la sortie 63 émet lors de leur présence un signal -s- qui est appliqué à une troisième entrée 68 de la porte OU 65.

Lors de l'apparition d'une surcharge modérée de courant comprise entre $I_n$ et 1,25 $I_n$, mais dont la durée est importante, le discriminateur 37 émet un signal -m- et le signal W représentant l'intégrale $\int i^2 dt$ est transmis à l'étage temporisateur 50 ; lorsque celui-ci émet un signal -x-, au terme d'un intervalle de temps inverse, les deux entrées de la porte ET 62 sont occupées par des signaux et un signal de surcharge prolongée -s- est transmis à la porte OU 65 dont la sortie émet un signal de blocage -b- au circuit de commande 30.

Lors de l'apparition d'une surcharge de courant comprise entre environ 1,25 fois et 6 fois le courant nominal $I_n$ et de courte durée, le signal -d- émis par le discriminateur 37 n'est pas accompagné de l'apparition du signal -x-, car l'intégrale $\int i^2 dt$ est trop faible, mais ce signal est appliqué sans délai au relais rapide 16 dont l'excitation provoque la fermeture de l'interrupteur 13 et permet donc à un courant dérivé $I_d$ important de circuler dans la branche 7 à travers la résistance 10 ; la propriété de cette résistance de bien supporter et de façon réversible des surcharges de courant de courtes durées permet de délester l'interrupteur statique d'une fraction importante du courant qui l'aurait traversé. Par ailleurs, l'augmentation de résistance ohmique de cette résistance provoque une diminution notable du courant dérivé dans la branche 7.

La durée d'une telle surcharge ne peut toutefois excéder une valeur qui peut être déterminée par un étage temporisateur réglable 57 à qui est communiqué le signal -d-. Lorsque cette durée est supérieure à une valeur choisie en fonction du courant nominal, de la nature de la charge, de ses propriétés thermiques et de sa fonction (par exemple démarrage d'un moteur), un signal -d'- qui est émis par cet étage 58 est transmis à l'entrée 67 de la porte OU 65 qui fait apparaître un signal de blocage -b- et le transmet au circuit de commande 30.

Lorsque l'interrupteur statique 5 est bloqué, le détecteur 21 ne décèle alors que la circulation d'un courant résiduel $I_r$ qui n'est pas suffisamment élevé pour qu'un signal -d- apparaisse à la sortie 39 ; l'électro-aimant 16 n'étant plus alimenté, l'interrupteur 13 s'ouvre en interrompant un faible courant allant vers la charge.

Si pendant la période plus prolongée de fonctionnement de l'étage 50 un courant de court-circuit détecté par le détecteur 21 se développe entre les bornes 2, 3 de l'appareil, les deux modes de fonctionnement précédents sont supplantés par un troisième mode de fonctionnement faisant intervenir soit simultanément l'intensité instantanée du courant et la valeur de sa croissance, soit séparément la croissance lorsque l'interrupteur 58 a été fermé préalablement.

Selon ce troisième mode de fonctionnement, qui peut aussi se développer sans que l'un des deux précédents soit antérieurement apparu, un signal -p- représentant la dérivée du courant élaborée dans le circuit dérivateur 41, est appliqué au détecteur de seuil 44 qui émet le signal -q- lorsque cette dérivée est supérieure à, par exemple, six fois la valeur maximum $P = 314 I_n$/sec que peut prendre la dérivée du courant nominal, tandis que le discriminateur 37 émet un signal -j- si la valeur instantanée de ce courant dépasse, par exemple, six fois la valeur de crête de l'intensité nominale $I_n$. Lorsque les deux signaux -q- et -j- sont simultanément appliqués aux entrées de la porte ET 54, un signal -c- qui est émis à la sortie est transmis à la porte ET 65 pour que soit émis sans aucun délai et envoyé au circuit de commande 30 un signal de blocage -b-.

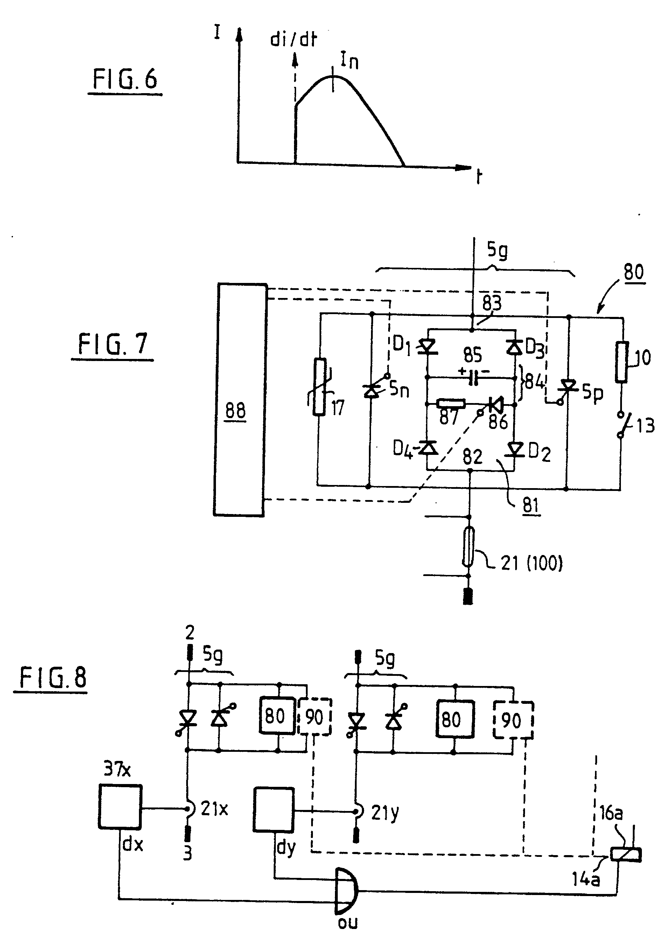

L'exploitation simultanée des signaux -j- et -q- permet d'éviter qu'un signal de blocage soit émis lorsque les propriétés de la charge provoquent l'apparition d'un courant de mise en service ayant une croissance instantanée très élevée sans que, pour autant, le courant de régime soit anormal ; un tel phénomène se produit par exemple lorsque l'alimentation d'une charge telle que les lampes à incandescence est opérée à un instant d'une période du courant alternatif, qui n'est pas voisine du passage au zéro, voir figure 6.

Lorsque le circuit de commande 30 a reçu un ordre de blocage b, il ne faut pas que la présence ou la réapparition d'un ordre de fermeture -f- à la borne de commande 35 provoque l'apparition immédiate d'un signal de conduction -e- sur l'entrée 32 du circuit de commande 30.

Un circuit inhibiteur tel que le circuit 34, ou une disposition interne particulière du circuit de commande 30 permettent, par exemple, d'assurer cette interdiction.

Ce circuit inhibiteur doit, par ailleurs, présenter des moyens de discrimination ou être associé à de tels moyens pour que cette interdiction soit, d'une part, automatiquement effacée au terme d'un certain intervalle de temps nécessaire à l'évacuation du surcroît d'énergie thermique de la charge lorsque le blocage a été provoqué par l'un des deux premiers modes de fonctionnement, et soit, d'autre part, maintenue lorsque le blocage résulte de l'apparition d'un courant de court-circuit dont la réapparition présenterait de graves dangers ; l'effacement de cette dernière interdiction doit naturellement résulter d'une intervention volontaire du personnel de maintenance.

Selon un mode de réalisation avantageux, le détecteur de courant 21 peut être constitué par un dispositif fusible 100 ayant une valeur ohmique constante et bien calibrée, voir figure 5. Les circuits détectant et exploitant dans ce cas l'image du courant n'ont pas été représentés.

Ce fil ou ruban fusible 100, qui est disposé dans une cartouche interchangeable 101 dont les broches 102, 103 coopèrent avec des bornes 104, 105 du boîtier 1 de l'appareil, voir figure 5, peut éventuellement servir à la définition du courant nominal de l'appareil ; la conformation de cette cartouche doit être par ailleurs telle qu'un fusible d'une intensité nominale supérieure ne puisse être associé à l'appareil.

Le circuit, qui est illustré à la figure 1, a été simplifié pour en faciliter la compréhension. Dans les appareils alimentés en courant alternatif, on dispose généralement deux interrupteurs statiques en tête-bêche pour utiliser les deux alternances d'une période de courant.

Alors que la constitution des branches 7 et 8 de la figure 1 placées en parallèle leur confère un fonctionnement identique lorsque des courants les traversent dans chacun des deux sens opposés, il n'en est pas de même pour la branche 9 contenant l'élément polarisé que constitue la diode 19.

Un circuit 80 susceptible de permettre à une branche 8 commune de coopérer de la même façon avec deux branches polarisées ayant chacune pour son sens propre la même fonction que celle de la branche 9, est visible à la figure 7, où, en parallèle sur deux interrupteurs statiques 5p, 5n montés en tête-bêche, se trouve disposé un pont de GRAETZ 81, équipé de diodes $D_1...D_4$, dont les sommets 82, 83 sont reliés en parallèle aux anodes et cathodes, et dont la diagonale 84 comporte un condensateur 85. Ce dernier peut donc être chargé selon un même sens par des courants circulant en sens inverse entre les bornes 2 et 3.

Afin de permettre des décharges successives et complètes de ce condensateur, qui sont toujours opérées dans un même sens inverse du précédent et doivent être terminées dans des délais très inférieurs à une demi-période de courant, on utilise un semi-conducteur commande 86 qui est placé en série avec une faible résistance 87, le tout étant placé en parallèle sur la diagonale 84 ; ce semi-conducteur est commandé par des signaux synchrones élaborés, par ailleurs, à partir d'une référence de courant du circuit de commande général 88.

Un appareil conforme à l'invention et prévu pour la surveillance des courants alternatifs polyphasés, comporte naturellement autant de groupes d'interrupteurs statiques 5g et d'éléments associés 2...21 ou circuits 80 que de phases ; les circuits 90 représentés à la figure 8 et contenant, par exemple, les branches 7 et 8 peuvent être associés à l'armature 14a d'un seul électro-aimant 16a recevant l'un des signaux $d_x$, $d_y$, émis par l'un des circuits 37x, 37y.

On pourra donc réduire le volume total de l'appareil en faisant actionner les divers interrupteurs tels que 13 par un seul et même électro-aimant 16a dont la bobine recevra l'un des signaux -d-.

Si l'on souhaite protéger des échauffements possibles non seulement la charge, mais encore les interrupteurs statiques, on donnera, par exemple, à deux des circuits 50 une caractéristique inverse particulièrement adaptée au comportement de ces interrupteurs lors du passage de courants trop importants.

Dans l'explication du fonctionnement du circuit mentionnée ci-dessous, on suppose que, compte tenu de la rapidité des phénomènes, la tension du réseau ne varie pas sensiblement en un point de son alternance.

Lors de l'apparition d'un courant de court-circuit d'intensité supérieure à 6 $I_n$, à l'instant -to-, des signaux -j-q- ou -k-, provoquent le blocage de l'interrupteur statique à l'instant -tl-, et la branche 7 reste ouverte.

Dès cet instant, un courant de charge du condensateur 20 à travers la diode 19 va circuler dans la branche 9 selon l'allure représentée de -pl- à -p2- entre -tl- et -t2-.

Cette évolution résulte du fait que, dès la fermeture de l'interrupteur, l'inductance L de la charge 24 joue le rôle d'un générateur de courant, qui fait encore croître son intensité selon une pente décroissante en raison de la charge progressive du condensateur.

Celui-ci voit augmenter sa tension $U_{20}$ à ses bornes jusqu'au moment -t2- où cette tension atteint une valeur égale à la tension de seuil $U_{17}$ de la résistance limitation de tension ; on assiste alors à un transfert du courant qui circule principalement dans cette résistance.

Au cours du processus suivant, une portion de l'énergie de l'inductance a servi à charger le condensateur, et le complément se dissipe maintenant dans la résistance 17, de sorte que le courant total ne peut que décroître. La portion de courbe -p2 p3- restitue l'allure de cette décroissance.

Lorsqu'à l'instant -t3- le courant atteint une valeur -i3- correspondant à celle qui est déterminée par le coude de la caractéristique de la résistance 17, le courant qui diminue résulte de la décharge du condensateur, et la tension baisse moins rapidement jusqu'au moment où celle-ci atteint une valeur égale à celle de la tension instantanée entre les bornes 2 et 3.

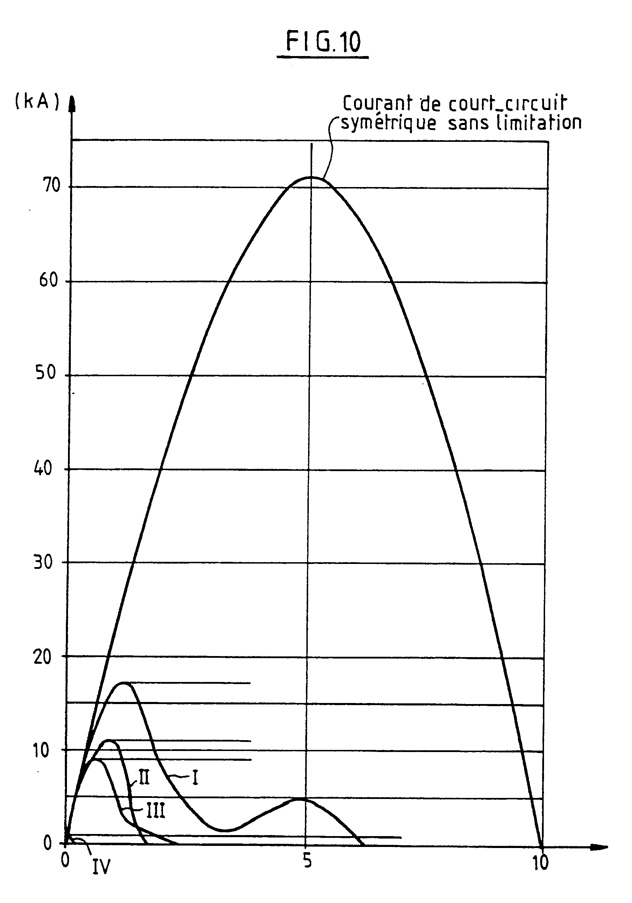

Les bonnes performances du circuit interrupteur qui vient d'être présenté tiennent pour part au choix d'une résistance limitatrice de tension, comprenant une céramique à base d'oxyde de Zinc ; bien que les caractéristiques de ces matériaux dans lesquels l'intensité admissible est estimée à environ 1 m A/ $cm^2$, ne semblent pas les destiner à des circuits de protections contre les surintensités de courant, le niveau élevé de leur tension de seuil ainsi que leur faculté de bien se comporter lors d'une courte surcharge énergétique concourent à l'obtention d'un résultat satisfaisant ; il est clair que l'association d'un tel moyen de limitation de tension avec un interrupteur statique implique que celui-ci soit choisi pour supporter une tension de l'ordre de 1 KV ; de cette manière la ligne se trouve protégée avec une grande efficacité comme en témoigne la figure 10, où la courbe IV représente le phénomène de limitation d'un appareil interrupteur selon l'invention.

Parallèlement à ce choix, la mise en oeuvre d'une résistance limitatrice de courant faisant appel à des polymères chargés, par exemple de carbone, de façon à les rendre conducteurs, permet un excellent transfert et une limitation de courant grâce à l'exploitation des intéressantes propriétés de ce matériau, dans lequel le phénomène de percolation développé lors de la circulation d'un courant important (et dont l'apparition est accidentelle) fait apparaître des phénomènes réversibles.

Selon un mode de réalisation particulier visible à la figure 4, l'électro-aimant 16, l'interrupteur 13 et la résistance 10 pourraient être disposés dans un sous-ensemble amovible 70 présentant des bornes 71, 72, 73, 74 de façon à pouvoir coopérer avec des bornes correspondantes placées sur un boîtier 75 d'appareil interrupteur 1$_a$.

Une telle mesure peut se justifier si l'appareil 1$_a$ est destiné à l'alimentation et à la protection d'une charge de nature particulière où une surintensité instantanée ne peut apparaître. Compte tenu des conditions dans lesquelles sont effectuées les ouvertures et fermetures de l'interrupteur 13, la taille de l'électro-aimant peut être très notablement réduite par rapport à celle qui serait nécessaire pour effectuer ces opérations en présence de courants et d'intensités nominaux.

Les organes 76, 77 représentent symboliquement des moyens de signalisation aptes à informer un opérateur ou le personnel de surveillance sur la nature des défauts apparus.

Les moyens 78, 79, 29 illustrent symboliquement des organes de réglage des circuits qui leur sont reliés et respectivement, un organe permettant de sélectionner un mode de fonctionnement particulier.

## Revendications

1. Appareil interrupteur électrique pour la commande de l'alimentation d'une charge inductive (24), cet appareil ayant entre deux bornes d'entrée (2) et de sortie (3) un composant semi-conducteur (5) apte à établir et interrompre le passage d'un courant alternatif entre ces bornes (2, 3) lorsqu'une électrode de commande (G) de ce composant (5) reçoit des signaux appropriés qui sont fournis par un circuit de commande recevant, d'une part, des ordres de conduction ou d'interruption correspondant à un fonctionnement normal et, d'autre part, des ordres de blocage qui sont émis lorsque l'intensité du courant, qui est mesurée par des moyens de détection (21) placés en série entre ces bornes (2, 3), subit une élévation anormale, caractérisé en ce que :

    – le susdit composant semi-conducteur (5) est de type blocable à tout moment de la période du courant alternatif,

    – une première branche conductrice (8) comprenant un élément résistif à seuil de courant élevé (17) est montée en parallèle entre les électrodes de puissance (A, K) du composant semi-conducteur (5),

    – une deuxième branche (9) incluant un condensateur (20) est montée en parallèle sur ledit élément résistif à seuil (17),

    l'élément résistif à seuil (17) étant apte à limiter la tension entre lesdites électrodes (A, K) et coopérant avec le condensateur (20) de la façon suivante :

    – à la suite de la fermeture du composant électronique (5), l'énergie mise en jeu par l'inductance de la charge, charge le condensateur (20), et

    – lorsque la tension aux bornes du condensateur (20) dépasse la tension de seuil de l'élément résistif (17), l'énergie accumulée par le condensateur (20) se décharge dans ledit élément résistif (17).

2. Appareil interrupteur selon la revendication 1, caractérisé en ce que, en parallèle sur la première branche (8) est placée une troisième branche (7) comprenant en série une résistance limitatrice de courant (10) apte à supporter une importante impulsion de courant et des contacts (11, 12) d'un interrupteur mécanique (13) non répulsif, qui est normalement ouvert, et dont la fermeture peut être établie par un relais rapide (16), la bobine (15) de ce relais n'étant alimentée que lors de l'apparition d'un premier type de défaut de durée limitée, pour lequel l'intensité présumée est sensiblement comprise entre 1,25 fois et 6 fois l'intensité nominale, et avant que soit transmis à l'électrode de commande (G) de l'interrupteur statique un signal de blocage -g-, tandis que cette bobine n'est pas alimentée et qu'un signal de blocage permanent est immédiatement fourni à cette électrode lorsqu'apparaît un gradient de courant supérieur à environ six fois le gradient de courant nominal -P- signalant l'apparition d'un second type de défaut.

3. Appareil interrupteur selon la revendication 1, caractérisé en ce qu'un circuit (9) respectivement (80), apte à protéger l'interrupteur statique (5, 5p, 5n) contre les gradients de tension, et comprenant une résistance (18, 87) et un condensateur (20, 85) associés à des moyens de charge unidirectionnels (19, 81), est placé en parallèle sur l'anode et la cathode de l'interrupteur statique (5) respectivement (5p, 5n).

4. Appareil interrupteur selon la revendication 3 et mettant en oeuvre un seul interrupteur statique, caractérisé en ce que ce circuit (9) comporte une résistance (18) montée en série avec un condensateur (20), une diode (19) étant placée en parallèle sur cette résistance dans le même sens de conduction que l'interrupteur statique (5).

5. Appareil interrupteur selon la revendication 3, et mettant en oeuvre deux interrupteurs statiques placés en tête-bêche, caractérisé en ce que les anodes et cathodes (AK) sont reliées aux sommets (82, 83), d'un pont de GRAETZ (81) à quatre diodes (D1...D4) dont la diagonale (84) comprend en parallèle, d'une part, un condensateur (85) et, d'autre part, un montage série d'une résistance (87) et d'un semi-conducteur commandé (86), un seul dispositif de transfert de courant (7) et un seul dispositif limiteur de tension (8) étant placés en parallèle sur les anodes et cathodes.

6. Appareil interrupteur selon la revendication 1, caractérisé en ce qu'un dispositif de protection à fusible calibré (100) est placé en série avec l'interrupteur statique (5), la tension aux bornes de ce fusible servant à l'élaboration d'une image du courant à travers le circuit (2, 3).

7. Appareil interrupteur selon la revendication 2, caractérisé en ce que l'interrupteur de transfert (13) comporte des moyens (28) propres à empêcher une répulsion électro-dynamique de son contact mobile (12).

8. Appareil interrupteur selon la revendication 2, caractérisé en ce que l'interrupteur de transfert (13) et son électro-aimant (16) ainsi que la résistance de transfert (10) sont disposés dans un module amovible (70) susceptible de s'associer au boîtier (75) de l'appareil.

9. Appareil interrupteur selon la revendication 1, caractérisé en ce que l'information de courant -i- émise par un détecteur de courant (21, 100) placé en série dans le circuit général (2, 3) est analysée par un circuit dérivateur (41), un circuit intégrateur (47) et un circuit discriminateur de niveaux (37) dont les signaux sont traités et logiquement combinés pour définir le mode de fonctionnement de l'interrupteur statique.

## Ansprüche

1. Elektrisches Schaltgerät, zur Steuerung der Versorgung einer induktiven Last (24), wobei dieses Gerät zwischen zwei Ein- (2) und Ausgangsklemmen (3) end Halbleiterbauteil (5) aufweist, welches den Wechselstromfluss zwischen besagten Klemmen (2, 3) bewirken und unterbrechen kann, wenn eine Steuerelektrode (G) dieses Bauteils (5) entsprechende Signale empfängt, die ihr von einem Steuerkreis übermittelt werden, der einerseits dem normalen Betrieb entsprechende Leit- oder Sperrbefehle erhält und andererseits Sperrbefehle, die abgegeben werden, wenn die Stromstärke, die von Erfassungsmitteln (21) gemessen wird, welche in Reihe zwischen besagten Klemmen (2, 3) angeordnet sind, sich abnorm erhöht, dadurch gekennzeichnet, dass :
- das besagte Halbleiterbauteil (5) so ausgelegt ist, dass es zu jeder Zeit während der Wechselstromperiode gesperrt werden kann,
- ein erster leitender Zweig (8) mit einem Starkstromschwellenwiderstandselement (17) parallel zwischen die Leistungselektroden (A, K) des Halbleiterbauteils (5) geschaltet ist,
- ein zweiter Zweig mit einem Kondensator (20) parallel zu besagtem Schwellenwiderstandselement (17) geschaltet ist,
und dass das Schwellenwiderstandselement (17) die Spannung zwischen besagten Elektroden (A, K) begrenzen kann und mit dem Kondensator (20) auf folgende Weise zusammenwirkt :
- infolge der Schliessung des elektronischen Bauteils (5) lädt die von der Induktanz der Last eingebrachte Energie den Kondensator (20) auf, und
- wenn die Spannung an den Klemmen des Kondensators (20) die Schwellenspannung des Widerstandselementes (17) übersteigt, entlädt sich die vom Kondensator (20) angesammelte Energie in besagtes Widerstandselement (17).

2. Schaltgerät nach Anspruch 1, dadurch gekennzeichnet, dass, parallel zum ersten Zweig (8) ein dritter Zweig (7) angeordnet ist, der in Reihe einen Strombegrenzungswiderstand (10) aufweist, welcher einen bedeutenden Stromimpuls aushält und Kontakte (11, 12) eines mechanischen, nicht abstossenden Schalters (13), der normalerweise geöffnet ist und dessen Schliessung durch ein Schnellrelais (16) bewirkt werden kann, wobei die Spule (15) dieses Relais nur mit Energie versorgt wird, wenn eine erste Art von Fehler von begrenzter Dauer auftritt, dessen angenommene Stromstärke etwa zwischen der 1,25 fachen und der sechsfachen Nominalstärke liegt und bevor der Steuerelektrode (G) des statischen Schalters ein Sperrsignal -g- übermittelt wird, während besagte Spule nicht versorgt wird und besagter Elektrode sofort ein Signal zur ständigen Sperrung übermittelt wird, wenn ein Stromgradifent auftritt, der etwa das sechsfache des Nominalstromgradienten -P- übersteigt und das Auftreten eines Fehlers der zweiten Art anzeigt.

3. Schaltgerät nach Anspruch 1, dadurch gekennzeichnet, dass ein Schaltkreis (9), bzw. (80), welcher den statischen Schalter (5, 5p, 5n) gegen die Spannungsgradienten schützt und einen Widerstand (18, 87) und einen Kondensator (20, 85) aufweist, denen Einwegauflademittel (19, 81) zugeordnet sind, parallel zur Anode und Kathode des statischen Schalters (5), bzw. (5p, 5n).

4. Schaltgerät nach Anspruch 3, welches einen einzigen statischen Schalter benutzt, dadurch gekennzeichnet, dass besagter Schaltkreis (9) einen in Reihe mit einem Kondensator (20) angeordneten Widerstand (18) aufweist, und eine Diode (19) mit besagtem Widerstand in der gleichen Leitrichtung wie der statische Schalter (5) parallelgeschaltet ist.

5. Schaltgerät nach Anspruch 3, welches zwei Kopf bei Fuss angeordnete statische Schalter benutzt, dadurch gekennzeichnet, dass die Anoden und Kathoden (A, K) an die Scheitelpunkte (82, 83) einer Gräetzbrücke (81) mit vier Dioden (D1... D4) angeschlossen sind, deren Diagonale (84), parallelgeschaltet, einerseits einen Kondensator (85) und andererseits in Reihe geschaltet einen Widerstand (87) und einen gesteuerten Halbleiter (86) aufweist und eine einzige Stromübertragungsvorrichtung (7) und eine einzige Strombegrenzungsvorrichtung (8) mit den Anoden und Kathoden parallelgeschaltet sind.

6. Schaltgerät nach Anspruch 1, dadurch gekennzeichnet, dass eine Schutzvorrichtung mit kalibrieter Sicherung (100) in Reihe mit dem statischen Schalter (5) geschaltet ist und die Spannung an den Klemmen dieser Sicherung dazu dient, ein Bild des Stroms im Schaltkreis (2, 3) auszuarbeiten.

7. Schaltgerät nach Anspruch 2, dadurch gekennzeichnet, dass der Übertragungsschalter (13) Mittel (28) zur Verhindenng des elektrodynamischen Abstosses seines beweglichen Kontaktes (12) aufweist.

8. Schaltgerät nach Anspruch 2, dadurch gekennzeichnet, dass der Übertragungsschalter (13) und sein Elektromagnet (16), sowie der Übertragungswiderstand (10) in einem abnehmbaren Modul (70) angeordnet sind, welches dem Gerätegehäuse (75) zugeordnet werden kann.

9. Schaltgerät nach Anspruch 1, dadurch gekennzeichnet, dass die Strominformation -i-, welche von einem im allgemeinen Schaltkreis (2, 3) in Reihe geschalteten Stromerfasser (21, 100) abgegeben wird, von einer Differenzierschaltung (41), einer Integrierschaltung (47) und einer Niveaudiskriminierschaltung (37) analysiert wird, deren Signale verarbeitet und logisch Kombiniert werden um den Betriebsmodus des Statischen Schalters zu definieren.

**Claims**

1. Electric switch device for controlling the power supply of an inductive load (24), said device having between two input (2) and output (3) terminals a semiconductor component (5) adapted for establishing and interrupting the passage of an AC current between said terminals (2, 3) when an electrode (G) controlling said component (5) receives appropriate signals which are delivered by a control circuit receiving, on the one hand, conduction or interruption orders corresponding to normal operation and, on the other hand, disabling orders which are emitted when the intensity of the current, which is measured by detection means (21) placed in series between these terminals (2, 3), undergoes an abnormal rise, characterized in that :

– said semiconductor component is of the type which may be disabled at any time of the AC period.

– a first conducting branch (8) comprising a high current threshold resistor element (17) is connected in parallel between the power electrodes (A, K) of the semiconductor component (5) ;

– a second branch (9) comprising a capacitor (20) is connected in parallel across said threshold resistor element (17),

the threshold resistor element (17) being adapted for limiting the voltage between said electrodes (A, K) and for cooperating with the capacitor in the following way :

– following closure of the electronic component (5), the energy provided by the inductance of the load charges capacitor (20), and

– when the voltage at the terminals of capacitor (20) is greater than the threshold voltage of the resistor element (17), the energy accumulated by the capacitor (20) discharges into said resistor element (17).

2. Switch device according to claim 1, characterized in that, in parallel across the first branch (8) is placed a third branch (7) including in series a current limiting resistor (10) adapted for withstanding a high current pulse and contacts (11, 12) of a non repulsive mechanical switch (13), which is normally open, and the closure of which may be established by a high speed relay (16), the coil (15) of this relay only being supplied with power when a first type of fault of limited duration appears, for which the presumed current is substantially between 1.25 times and 6 times the nominal current, and before a disabling signal -g- is transmitted to the control electrode (G) of the static switch, whereas this coil is not supplied with power and a permanent disabling signal is immediately delivered to this electrode when a current gradient appears greater than about six times the nominal current gradient -P- signalling the appearance of a second type of fault.

3. Switch device according to claim 1, characterized in that a circuit (9) respectively (80), adapted for protecting the static switch (5, 5p, 5n) against the voltage gradients and including a resistor (18, 87) and a capacitor (20, 85) associated with unidirectional charge means (19, 81), is placed in parallel across the anode and the cathode of the static switch (9), respectively (5p, 5n).

4. Switch device according to claim 3 and using a single static switch, characterized in that this circuit (9) includes a resistor (18) connected in series with a capacitor (20), a diode (19) being placed in parallel across the resistor in the same direction of conduction as the static switch (5).

5. Switch device according to claim 3, and using two static switches placed head to tail, characterized in that the anodes and cathodes (AK) are connected to the apices (82, 83) of a GRAETZ bridge (81) including four diodes (D1...D4) whose diagonal (84) includes in parallel, on the one hand, a capacitor (85) and, on the other, a series circuit of a resistor (87) and a controlled semiconductor (86), a single current transfer device (7) and a single voltage limiting device (8) being placed in parallel across the anodes and the cathodes.

6. Switch device according to claim 1, characterized in that a calibrated fuse protection device (100) is placed in series with the static switch (5), the voltage at the terminals of this fuse serving for elaborating an image of the current through the circuit (2, 3).

7. Switch device according to claim 2, characterized in that the transfer switch (13) includes means (28) adapted for preventing an electro-dynamic repulsion of its mobile contact (12).

8. Switch device according to claim 2, characterized in that the transfer switch (13) and its electromagnet (16) as well as the transfer resistor (10) are disposed in a removable module (70) able to be associated with the case (75) of the device.

9. Switch device according to claim 1, characterized in that the current information -i- emitted by a current detector (21, 100) placed in series in the general circuit (2, 3) is analysed by a shunt circuit (41), an integrator circuit (47) a level discriminator circuit (37) whose signals are processed and combined logically for defining the operating mode of the static switch.

FIG.1

EP 0 224 535 B1

FIG. 2

W

H

r

r′

Δr′₁  Δr₁  X  Δr₁

FIG. 3

12  28

11  13  16  15

FIG. 4

73

1a

75

74

10

70

16  13

71  72

FIG. 5

104

102  101

21

103  100

105

3

FIG.6

FIG.7

FIG.8

FIG. 9

## FIG.10